# EUROPEAN PATENT SPECIFICATION

(11) **EP 4 167 475 B1**
(45) Date of publication and mention of the grant of the patent: **02.12.2026**
(21) Application number: 22200111.7
(22) Date of filing: 06.10.2022
(51) Int. Cl.: H03F 1/02, H03F 3/19, H03F 3/24

(54) **CIRCUIT AND METHOD FOR INTER-SYMBOL AND INTRA-SYMBOL VOLTAGE MODULATION**
SCHALTUNG UND VERFAHREN ZUR INTERSYMBOL- UND INTRASYMBOLSPANNUNGSMODULATION
CIRCUIT ET PROCÉDÉ DE MODULATION DE TENSION ENTRE SYMBOLES ET INTRA-SYMBOLES

(30) Priority: 14.10.2021 US 202163255656 P; 14.10.2021 US 202163255659 P; 19.09.2022 US 202217947567
(43) Date of publication of application: 19.04.2023
(73) Proprietor: Qorvo US, Inc., Greensboro, NC 27409 (US)
(72) Inventor: KHLAT, Nadim, 31770 Colomiers (FR); RETZ, James M., Iowa, 52233 (US); NGUYEN, Arthur, Greensboro, 27409 (US)
(74) Representative: D Young & Co LLP

(56) References cited:
- US-A1- 2020 321 917

## Description

### Related Applications

This application claims the benefit of U.S. provisional patent application serial number 63/255,659 filed on October 14, 2021, and U.S. provisional patent application serial number 63/255,656 filed on October 14, 2021.

### Field

The technology of the disclosure relates generally to inter-symbol and intra-symbol voltage modulation.

### Background

Fifth generation (5G) new radio (NR) (5G-NR) has been widely regarded as the next generation of wireless communication technology beyond the current third generation (3G) and fourth generation (4G) technologies. In this regard, a wireless communication device capable of supporting the 5G-NR wireless communication technology is expected to achieve higher data rates, improved coverage range, enhanced signaling efficiency, and reduced latency.

Downlink and uplink transmissions in a 5G-NR system are widely based on orthogonal frequency division multiplexing (OFDM) technology. In an OFDM based system, physical radio resources are divided into a number of subcarriers in a frequency domain and a number of OFDM symbols in a time domain. The subcarriers are orthogonally separated from each other by a subcarrier spacing (SCS). The OFDM symbols are separated from each other by a cyclic prefix (CP), which acts as a guard band to help overcome inter-symbol interference (ISI) between the OFDM symbols.

A radio frequency (RF) signal communicated in the OFDM based system is often modulated into multiple subcarriers in the frequency domain and multiple OFDM symbols in the time domain. The multiple subcarriers occupied by the RF signal collectively define a modulation bandwidth of the RF signal. The multiple OFDM symbols, on the other hand, define multiple time intervals during which the RF signal is communicated. In the 5G-NR system, the RF signal is typically modulated with a high modulation bandwidth in excess of 200 MHz.

The duration of an OFDM symbol depends on the SCS and the modulation bandwidth. The table below (Table 1) provides some OFDM symbol durations, as defined by 3G partnership project (3GPP) standards for various SCSs and modulation bandwidths. Notably, the higher the modulation bandwidth is, the shorter the OFDM symbol duration will be. For example, when the SCS is 120 KHz and the modulation bandwidth is 400 MHz, the OFDM symbol duration is 8.93 µs.

**Table 1**

| SCS (KHz) | CP (µs) | OFDM Symbol Duration (µs) | Modulation Bandwidth (MHz) |
|---|---|---|---|
| 15 | 4.69 | 71.43 | 50 |
| 30 | 2.34 | 35.71 | 100 |
| 60 | 1.17 | 17.86 | 200 |
| 120 | 0.59 | 8.93 | 400 |

In a 5G-NR system, the RF signal can be modulated with a time-variant power that changes from one OFDM symbol to another. In this regard, a power amplifier circuit(s) is required to amplify the RF signal to a certain power level within each OFDM symbol duration. Such inter-symbol power variation creates a unique challenge for a power management integrated circuit (PMIC) because the PMIC must be able to adapt a modulated voltage supplied to the power amplifier circuit within the CP of each OFDM symbol to help avoid distortion (e.g., amplitude clipping) in the RF signal.

US 2020/0321917 A1 describes a symbol power tracking amplification system and a wireless communication device including the same.

### Summary

Particular aspects are set out in the appended independent claims. Various optional embodiments are set out in the dependent claims.

Embodiments of the disclosure relate to a circuit and method for inter-symbol and intra-symbol voltage modulation. Herein, a transceiver circuit is configured to determine a voltage target(s) and provide the voltage target(s) to a power management integrated circuit (PMIC) for generating a modulated voltage(s) to amplify a radio frequency (RF) signal modulated in multiple symbols. Specifically, the transceiver circuit will generate multiple voltage targets for any of the symbols to thereby enable intra-symbol voltage modulation when the respective symbol is modulated to carry a selected type of information (e.g., control information). In contrast, the transceiver circuit will generate a single voltage target for any of the symbols to thereby enable inter-symbol voltage modulation when the respective symbol is not modulated to carry the selected type of information. By dynamically performing inter-symbol and intra-symbol voltage modulation based on the type of information carried in a symbol(s), the modulated voltage can be timely adapted to closely track a time-variant power envelope of the RF signal to thereby avoid potential distortion (e.g., amplitude clipping) and protect critical information in the RF signal.

In one aspect, a transceiver circuit is provided. The transceiver circuit includes a digital baseband circuit. The digital baseband circuit is configured to generate an input vector including a selected type of information modulated in one or more of multiple symbols. The transceiver circuit also includes a target voltage circuit. The target voltage circuit is configured to determine multiple voltage modulation intervals corresponding to the multiple symbols, respectively. The target voltage circuit is also configured to divide a respective one of the multiple voltage modulation intervals into multiple voltage modulation subintervals each including a respective one of multiple voltage targets when a corresponding one of the multiple symbols includes the selected type of information. The target voltage circuit is also configured to generate a respective one of multiple target voltage indications including the multiple voltage targets.

In another aspect, a transmission circuit is provided. The transmission circuit includes a transceiver circuit. The transceiver circuit includes a digital baseband circuit. The digital baseband circuit is configured to generate an input vector including a selected type of information modulated in one or more of multiple symbols. The transceiver circuit also includes a target voltage circuit. The target voltage circuit is configured to determine multiple voltage modulation intervals corresponding to the multiple symbols, respectively. The target voltage circuit is also configured to divide a respective one of the multiple voltage modulation intervals into multiple voltage modulation subintervals each including a respective one of multiple voltage targets when a corresponding one of the multiple symbols includes the selected type of information. The target voltage circuit is also configured to generate a respective one of multiple target voltage indications including the multiple voltage targets. The transmission circuit also includes a PMIC. The PMIC includes a voltage generation circuit. The voltage generation circuit is configured to receive the multiple target voltage indications from the transceiver circuit. The voltage generation circuit is also configured to generate multiple modulated voltages in the multiple voltage modulation subintervals based on the multiple voltage targets, respectively.

In another aspect, a method for enabling inter-symbol and intra-symbol voltage modulation is provided. The method includes generating an input vector including a selected type of information modulated in one or more of multiple symbols. The method also includes determining multiple voltage modulation intervals corresponding to the multiple symbols, respectively. The method also includes dividing a respective one of the multiple voltage modulation intervals into multiple voltage modulation subintervals each including a respective one of multiple of voltage targets when a corresponding one of the multiple symbols includes the selected type of information. The method also includes generating a respective one of multiple target voltage indications including the multiple voltage targets. The method also includes generating multiple modulated voltages in the multiple voltage modulation subintervals based on the multiple voltage targets, respectively.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.
Figure 1 illustrates example time slot(s) and a mini time slot(s) as widely supported in a fifth generation (5G) or a 5G new-radio (5G-NR) system;
Figure 2 is a schematic diagram of an example transmission circuit wherein a power management integrated circuit (PMIC) and a transceiver circuit are configured according to embodiments of the present disclosure to enable inter-symbol and intra-symbol voltage modulation;
Figures 3A and 3B are block diagrams providing example illustrations of a target voltage indication generated by the transceiver circuit in Figure 2 to cause the PMIC to perform the intra-symbol voltage modulation;
Figure 4 is a block diagram providing an example illustration as to how the PMIC in Figure 2 can perform the intra-symbol voltage modulation;
Figure 5 is a schematic diagram of an example voltage modulation circuit, which can be provided in the PMIC in Figure 2 to perform inter-symbol and intra-symbol voltage modulation during the voltage modulation interval(s);
Figure 6 is a schematic diagram illustrating the transceiver circuit in Figure 2 configured to enable inter-symbol and intra-symbol voltage modulation; and
Figure 7 is a flowchart of an example process for enabling inter-symbol and intra-symbol voltage modulation according to embodiments of the present disclosure.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments of the disclosure relate to circuit and method for inter-symbol and intra-symbol voltage modulation. Herein, a transceiver circuit is configured to determine a voltage target(s) and provide the voltage target(s) to a power management integrated circuit (PMIC) for generating a modulated voltage(s) to amplify a radio frequency (RF) signal modulated in multiple symbols. Specifically, the transceiver circuit will generate multiple voltage targets for any of the symbols to thereby enable intra-symbol voltage modulation when the respective symbol is modulated to carry a selected type of information (e.g., control information). In contrast, the transceiver circuit will generate a single voltage target for any of the symbols to thereby enable inter-symbol voltage modulation when the respective symbol is not modulated to carry the selected type of information. By dynamically performing inter-symbol and intra-symbol voltage modulation based on the type of information carried in a symbol(s), the modulated voltage can be timely adapted to closely track a time-variant power envelope of the RF signal to thereby avoid potential distortion (e.g., amplitude clipping) and protect critical information in the RF signal.

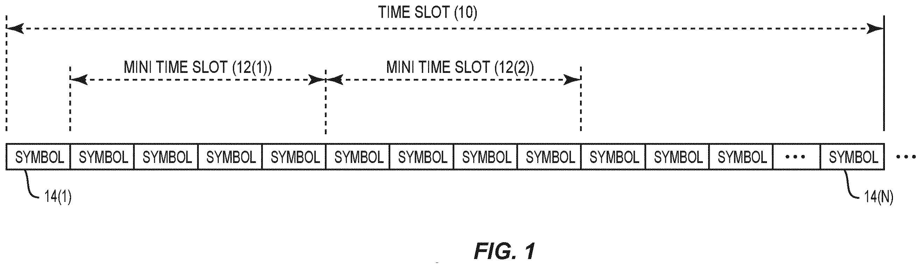

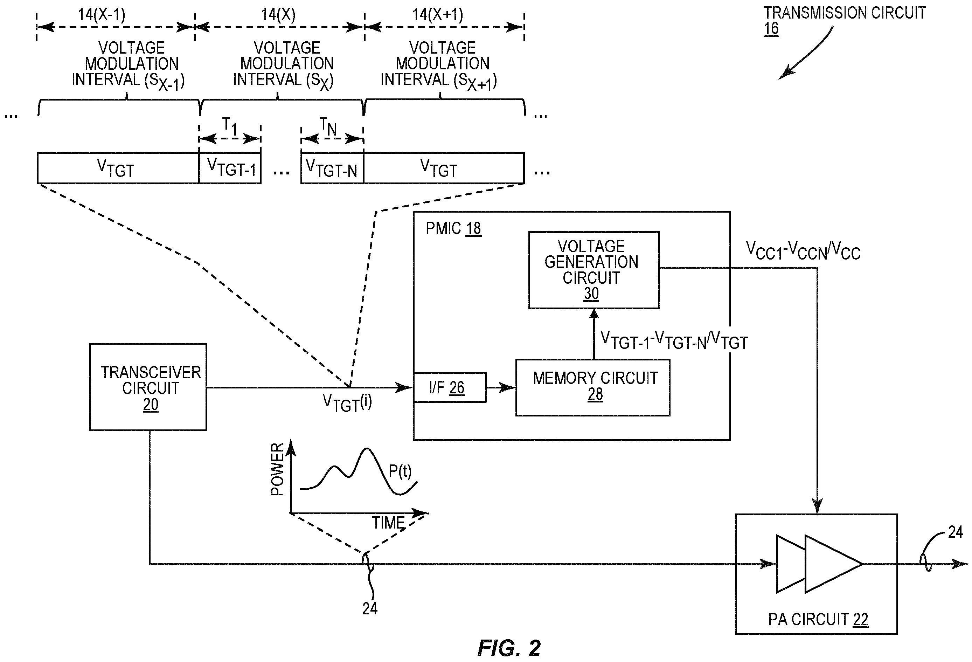

Before discussing inter-symbol and intra-symbol voltage modulation of the present disclosure, starting at Figure 2, an overview of orthogonal frequency division multiplexing (OFDM) symbols, which can be used to define durations of voltage modulation intervals, is first provided with reference to Figure 1.

Figure 1 illustrates example time slot(s) 10 and a pair of mini time slots 12(1)-12(2) as widely supported in a fifth generation (5G) and 5G new-generation (5G-NR) system. The time slot(s) 10, which can represent any one or more of multiple continuous time slots, includes multiple symbols 14(1)-14(N), such as OFDM symbols. The mini time slots 12(1)-12(2) can each include at least two of the symbols 14(1)-14(N). In the example shown in Figure 1, each of the mini time slots 12(1)-12(2) includes four of the symbols 14(1)-14(N). As previously shown in Table 1, each of the symbols 14(1)-14(N) has a symbol duration that depends on the subcarrier spacing (SCS). Once the SCS is chosen, the duration and the CP of each of the symbols 14(1)-14(N) are set accordingly.

The symbols 14(1)-14(N) in the time slot(s) 10 can be modulated based on any type of modulation and coding scheme (MCS) to carry various types of information. For example, some of the symbols 14(1)-14(N) can be modulated to carry downlink/uplink control information, some of the symbols 14(1)-14(N) can be modulated to carry downlink/uplink data payload, and yet some of the symbols 14(1)-14(N) can be empty (e.g., not bearing any information). Among the symbols 14(1)-14(N), those symbols that are modulated to carry a selected type of information are of special importance in the context of the present disclosure.

Herein, the selected type of information may include information related to physical downlink control channel (PDCCH), physical uplink control channel (PUCCH), physical downlink shared channel (PDSCH), and/or physical uplink shared channel (PUSCH). In a non-limiting example, the selected type of information can be a sounding reference signal (SRS), a demodulation reference signal (DMRS), and so on. As described in detail below, whether the selected type of information is present or absent in any of the symbols 14(1)-14(N) is a determining factor for intra-symbol or inter-symbol voltage modulation.

Figure 2 is a schematic diagram of an example transmission circuit 16 wherein a PMIC 18 and a transceiver circuit 20 are configured according to embodiments of the present disclosure to enable inter-symbol and intra-symbol voltage modulation. The transmission circuit 16 also includes a power amplifier circuit 22. The power amplifier circuit 22 is configured to amplify an RF signal 24 based on a modulated voltage V_{CC}, which can be an envelope tracking (ET) modulated voltage or an average power tracking (APT) modulated voltage. The PMIC 18 is configured to generate the modulated voltage V_{CC} and the transceiver circuit 20 is configured to generate the RF signal 24.

The transceiver circuit 20 is configured to modulate the RF signal 24 onto the symbols 14(1)-14(N) in Figure 1. Herein, three consecutive symbols 14(X-1), 14(X), 14(X+1) among the symbols 14(1)-14(N) (X > 1, N ≥ X+1) are illustrated as an example. As described above, some of the symbols 14(X-1), 14(X), 14(X+1) may be modulated to carry the selected type of information, while some other ones of the symbols 14(X-1), 14(X), 14(X+1) may not. As an example, it is assumed that the symbol 14(X) is modulated to carry the selected type of information, and symbols 14(X-1) and 14(X+1) do not contain the selected type of information. In this regard, as further described below, the transmission circuit 16 will perform intra-symbol voltage modulation during the symbol 14(X) and inter-symbol voltage modulation during the symbols 14(X-1) and 14(X+1).

Herein, intra-symbol voltage modulation means that the PMIC 18 can change the modulated voltage V_{CC} multiple times during the symbol 14(X). In contrast, inter-symbol voltage modulation means that the PMIC 18 does not change the modulated voltage V_{CC} during any of the symbols 14(X-1) and 14(X+1). However, with inter-symbol voltage modulation, the PMIC 18 can still change the modulated voltage V_{CC} between the symbols 14(X-1) and 14(X+1). In other words, the modulated voltage V_{CC} in the symbol 14(X-1) can be identical to or different from the modulated voltage V_{CC} in the symbol 14(X+1).

In an embodiment, the transceiver circuit 20 is configured to generate multiple target voltage indications V_{TGT}(i) (i = X-1, X, X+1) in multiple voltage modulation intervals S_{X-1}, S_{X}, S_{X+1}, respectively. Each of the voltage modulation intervals S_{X-1}, S_{X}, S_{X+1} correspond to a respective one of the symbols 14(X-1), 14(X), 14(X+1). In other words, there exists a one-to-one relationship between the voltage modulation intervals S_{X-1}, S_{X}, S_{X+1} and the symbols 14(X-1), 14(X), 14(X+1). Notably, the voltage modulation intervals S_{X-1}, S_{X}, S_{X+1} represent three consecutive voltage modulation intervals among any number of voltage modulation intervals, so chosen for the sole purpose of illustration. Understandably, the voltage modulation interval S_{X-1} is an immediately preceding voltage modulation interval of the voltage modulation interval S_{X}, the voltage modulation interval S_{X} is an immediately preceding voltage modulation interval of the voltage modulation interval S_{X+1}, and so on.

According to an embodiment of the present disclosure, the PMIC 18 includes an inter-chip interface 26, a memory circuit 28, and a voltage generation circuit 30. In a non-limiting example, the inter-chip interface 26 can be a multiwire interface, such as an RF front-end (RFFE) interface, that is coupled to the transceiver circuit 20. The transceiver circuit 20 is configured to provide a respective target voltage indication V_{TGT}(i) (i = X-1, X, X+1, and so on) for each of the voltage modulation intervals S_{X-1}, S_{X}, S_{X+1}.

Specifically, to enable to PMIC 18 to perform inter-symbol voltage modulation, the transceiver circuit 20 is configured to determine and provide a single voltage target V_{TGT} to the PMIC 18 in the target voltage indications V_{TGT}(i) (i = X-1, X+1). Accordingly, the PMIC 18 will generate the modulated voltage V_{CC} during the voltage modulation intervals S_{X-1}, S_{X+1} based on the respective voltage target V_{TGT} received in the target voltage indications V_{TGT}(i) (i = X-1, X+1).

Notably, the transceiver circuit 20 is configured to generate the RF signal 24 with a time-variant power envelope P(t) that can increase or decrease multiple times during each of the symbols 14(X-1), 14(X), 14(X+1). In this regard, since the symbol 14(X) includes the selected type of information, it is desirable that the PMIC 18 can generate multiple modulated voltages V_{CC1}-V_{CCN} during the voltage modulation interval S_{X} to better track (increase or decrease) the time-variant power envelope P(t) on an intra-symbol basis to help avoid potential distortion (e.g., amplitude clipping) to the RF signal 24 when the RF signal 24 is amplified by the power amplifier circuit 22.

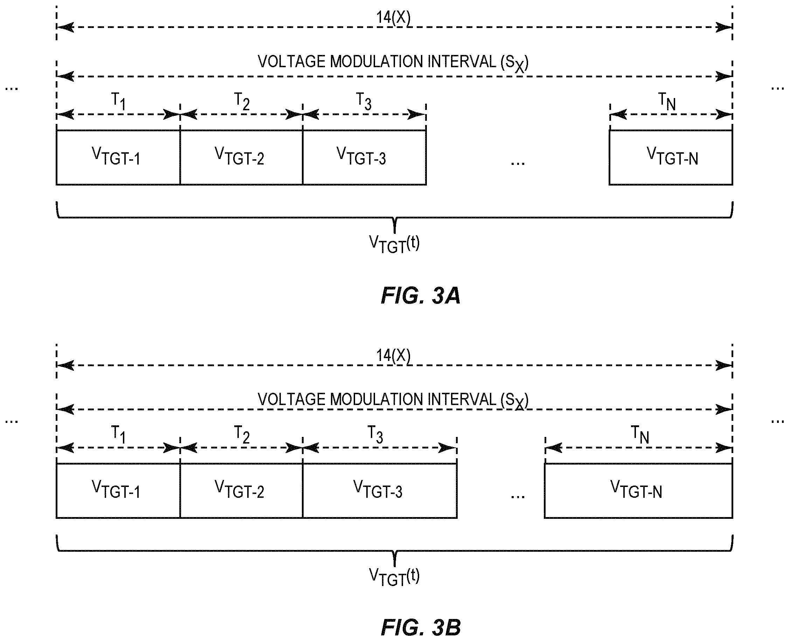

Figures 3A and 3B are block diagrams providing example illustrations of the target voltage indication V_{TGT}(i) (i = X) generated by the transceiver circuit 20 in Figure 2 to cause the PMIC 18 to perform the intra-symbol voltage modulation during the voltage modulation interval S_{X}. Common elements between Figures 2 and 3A-3B are shown therein with common element numbers and will not be re-described herein.

In one embodiment, as illustrated in Figure 3A, the transceiver circuit 20 can divide the voltage modulation intervals S_{X} equally such that each of the modulation subintervals T₁-T_{N} will have an identical duration.

In another embodiment, as illustrated in Figure 3B, the transceiver circuit 20 can divide the voltage modulation interval S_{X} unequally such that each of the modulation subintervals T₁-T_{N} will have different durations. For example, the transceiver circuit 20 can make any of the modulation subintervals T₁-T_{N} longer if a variation of the modulated voltage V_{CC} exceeds a preset threshold between adjacent ones of the modulation subintervals T₁-T_{N}, or make any of the modulation subintervals T₁-T_{N} shorter if the modulated voltage V_{CC} remains unchanged or the variation of the modulated voltage V_{CC} is below the preset threshold in between the adjacent ones of the modulation subintervals T₁-T_{N}.

With reference back to Figure 2, the transceiver circuit 20 is also configured to set the voltage targets V_{TGT-1}-V_{TGT-N} for each of the modulation subintervals T₁-T_{N} based on the time-variant power envelope P(t) of the RF signal 24. In a non-limiting example, the transceiver circuit 20 can set a respective one of the voltage targets V_{TGT-1}-V_{TGT-N} for a respective one of the modulation subintervals T₁-T_{N} based on a maximum of the time-variant power envelope P(t) during the respective one of the modulation subintervals T₁-T_{N}.

The transceiver circuit 20 is configured to write the voltage targets V_{TGT-1}-V_{TGT-N}, in association with the modulation subintervals T₁-T_{N}, into the memory circuit 28 via the inter-chip interface 26. In one embodiment, the transceiver circuit 20 may write the voltage targets V_{TGT-1}-V_{TGT-N} associated with the voltage modulation interval S_{X} prior to a start of the voltage modulation interval S_{X}. In particular implementations, the transceiver circuit 20 will write the voltage targets V_{TGT-1}-V_{TGT-N} associated with the voltage modulation interval S_{X} during an immediately preceding one of the voltage modulation intervals S_{X-1}, S_{X}, S_{X+1}. For example, the transceiver circuit 20 will write the voltage targets V_{TGT-1}-V_{TGT-N} associated with the voltage modulation interval S_{X} during the voltage modulation interval S_{X-1}.

Prior to the voltage modulation interval S_{X}, the voltage generation circuit 30 retrieves the voltage targets V_{TGT-1}-V_{TGT-N}, in association with the modulation subintervals T₁-T_{N}, from the memory circuit 28. Accordingly, the voltage generation circuit 30 can generate the modulated voltages V_{CC-1}-V_{CC-N} during the modulation subintervals T₁-T_{N} based on the voltage targets V_{TGT-1}-V_{TGT-N}, respectively.

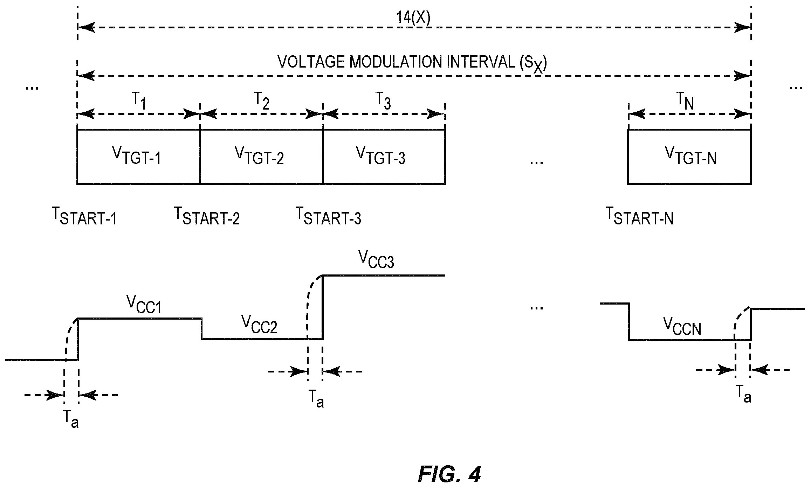

Figure 4 is a block diagram providing an example illustration as to how the PMIC 18 in Figure 2 can perform intra-symbol voltage modulation during the voltage modulation interval S_{X}. Common elements between Figures 2 and 4 are shown therein with common element numbers and will not be re-described herein.

The voltage generation circuit 30 is configured to determine multiple starts T_{START-1}-T_{START-N} of the modulation subintervals T₁-T_{N}, respectively. In a non-limiting example, the voltage generation circuit 30 can receive the start T_{START-1}-T_{START-N} of the modulation subintervals T₁-T_{N} from the transceiver circuit 20 together with or separately from the voltage targets V_{TGT-1}-V_{TGT-N}. Accordingly, the voltage generation circuit 30 can generate each of the modulated voltages V_{CC-1}-V_{CC-N} no later than a respective one of the determined **start** T_{START-1}-T_{START-N} of the voltage modulation subintervals T₁-T_{N}.

According to an embodiment of the present disclosure, the voltage generation circuit 30 is configured to determine whether each of the modulated voltages V_{CC-1}-V_{CC-N} is set to increase or decrease during a respective one of the modulation subintervals T₁-T_{N}. If any of the modulated voltages V_{CC-1}-V_{CC-N} is set to increase during the respective one of the modulation subintervals T₁-T_{N}, the voltage generation circuit 30 may start transitioning to the respective one the modulated voltages V_{CC-1}-V_{CC-N} prior to the respective start T_{START-1}-T_{START-N} of the respective one of the modulation subintervals T₁-T_{N}. For example, the voltage generation circuit 30 determines that the modulated voltages V_{CC-1} and V_{CC-3} are set to increase during the modulation subintervals T₁ and T₃, respectively. Accordingly, the voltage generation circuit 30 will start transitioning to the modulated voltages V_{CC-1} and V_{CC-3} with a timing advance Tₐ prior to the respective starts T_{START-1} and T_{START-3} of the modulation subintervals T₁ and T₃. By starting the transition with the timing advance Tₐ, the voltage generation circuit 30 can ensure that the modulated voltages V_{CC-1} and V_{CC-3} can be ramped up to desired levels in time to help avoid amplitude clipping in the RF signal 24.

In contrast, if any of the modulated voltages V_{CC-1}-V_{CC-N} is set to increase, or remain unchanged, during the respective one of the modulation subintervals T₁-T_{N}, the voltage generation circuit 30 may start transitioning to the respective one the modulated voltages V_{CC-1}-V_{CC-N} at the respective start T_{START-1}-T_{START-N} of the respective one of the modulation subintervals T₁-T_{N}. For example, the voltage generation circuit 30 determines that the modulated voltages V_{CC-2} and V_{CC-N} are set to decrease during the modulation subintervals T₂ and T_{N}, respectively. Accordingly, the voltage generation circuit 30 will start transitioning to the modulated voltages V_{CC-2} and V_{CC-N} right at the respective starts T_{START-2} and T_{START-N} of the modulation subintervals T₂ and T_{N}.

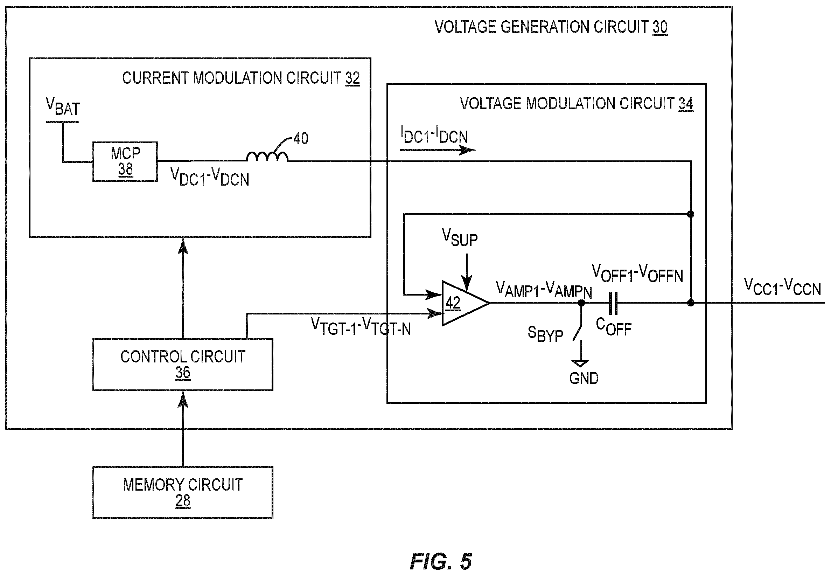

Figure 5 is a schematic diagram of the voltage generation circuit 30 configured according to an embodiment of the present disclosure. Common elements between Figures 2 and 5 are shown therein with common element numbers and will not be re-described herein.

Herein, the voltage generation circuit 30 includes a current modulation circuit 32, a voltage modulation circuit 34, and a control circuit 36. The current modulation circuit 32 includes a multi-level charge pump (MCP) 38 and a power inductor 40. During the voltage modulation interval S_{X}, the MCP 38 is configured to generate multiple low-frequency voltages V_{DC-1}-V_{DCN}, each as a function of a battery voltage V_{BAT}, during the modulation subintervals T₁-T_{N}, respectively. Accordingly, in the voltage modulation interval S_{X}, the power inductor 40 is configured to induce multiple low frequency currents I_{DC1}-I_{DCN} based on the low-frequency voltages V_{DC-1}-V_{DCN}, respectively.

The voltage modulation circuit 34 includes a voltage amplifier 42, an offset capacitor C_{OFF}, and a bypass switch S_{BYP}. The voltage amplifier 42 is configured to generate multiple modulated initial voltages V_{AMP1}-V_{AMPN} based on the voltage targets V_{TGT-1}-V_{TGT-N} in the modulation subintervals T₁-T_{N}, respectively. The offset capacitor C_{OFF} is modulated by the low frequency currents I_{DC1}-I_{DCN} to multiple offset voltages V_{OFF1}-V_{OFFN} in the modulation subintervals T₁-T_{N}, respectively. Each of the offset voltages V_{OFF1}-V_{OFFN} will raise a respective one of the modulated initial voltages V_{AMP1}-V_{AMPN} to a respective one of the modulated voltages V_{CC1}-V_{CCN}. For specific example as to how the offset voltages V_{OFF1}-V_{OFFN} can be modulated by the low frequency currents I_{DC1}-I_{DCN} to raise the modulated initial voltages V_{AMP1}-V_{AMPN} to the modulated voltages V_{CC1}-V_{CCN}, please refer to U.S. Patent Application Number 17/946,224, entitled "MULTI-VOLTAGE GENERATION CIRCUIT."

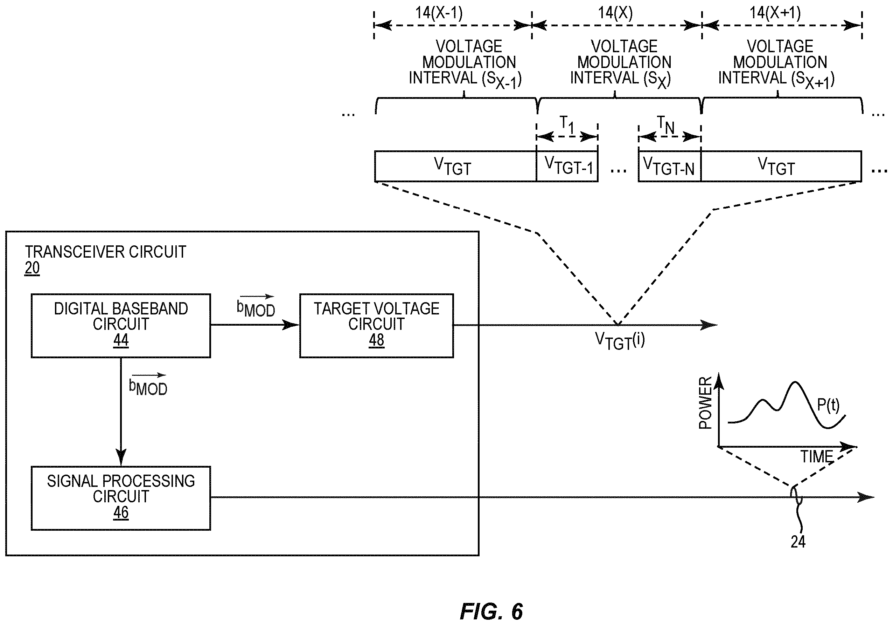

Figure 6 is a schematic diagram illustrating the transceiver circuit 20 in Figure 2 configured to enable inter-symbol and intra-symbol voltage modulation. Common elements between Figures 2 and 6 are shown therein with common element numbers and will not be re-described herein.

Herein, the transceiver circuit 20 includes a digital baseband circuit 44, a signal processing circuit 46, and a target voltage circuit 48. The digital baseband circuit 44 is configured to generate an input vector b̅_̅{̅M̅O̅D̅}̅ modulated in the symbols 14(X-1), 14(X), 14(X+1). According to the example described above, the symbol 14(X) is modulated to include the selected type of information, while the symbols 14(X-1) and 14(X+1) are not. In an embodiment, the digital baseband circuit 44 may determine which of the symbols 14(X-1), 14(X), 14(X+1) will be modulated with the selected type of information based on system configuration. For example, in a 5G or 5G-NR system, the exact symbol location of the selected type of information can be predefined in a standard, such as a third-generation partnership project (3GPP) standard.

The signal processing circuit 46, which may include digital-to-analog converter (DAC) and frequency converter (not shown), is configured to generate the RF signal 24 from the input vector b̅_̅{̅M̅O̅D̅}̅ and provide the RF signal 24 to the power amplifier circuit 22 in Figure 2.

In an embodiment, the target voltage circuit 48 may include an internal memory and an internal processor, which are not shown herein for the sake of simplicity. The internal memory, which can be any type of memory, may store a target voltage lookup table (LUT) that correlates a time-variant amplitude of the input vector b̅_̅{̅M̅O̅D̅}̅ with various levels of voltage targets. The internal memory may also store the exact symbol location of the selected type of information such that the internal processor (e.g., a digital signal processor) in the target voltage circuit 48 can determine whether the selected type of information is modulated in any of the symbols 14(X-1), 14(X), 14(X+1). Alternatively, the digital baseband circuit 44 may provide an indication to the target voltage circuit 48 as to which of the symbols 14(X-1), 14(X), 14(X+1) is modulated with the selected type of information.

The target voltage circuit 48 is configured to determine the voltage modulation intervals S_{X-1}, S_{X}, S_{X+1} that correspond respectively to the symbols 14(X-1), 14(X), 14(X+1). In one embodiment, the internal processor of the target voltage circuit 48 determines that the symbol 14(X) is modulated to include the selected type of information. Accordingly, the internal processor in the target voltage circuit 48 divides the voltage modulation interval S_{X} into the voltage modulation subintervals T₁-T_{N} and uses the target voltage LUT to generate the voltage targets V_{TGT-1}-V_{TGT-N} for the voltage modulation subintervals T₁-T_{N}, respectively. In another embodiment, the internal processor in the target voltage circuit 48 determines that the symbols 14(X-1) and 14(X+1) are not modulated to include the selected type of information. Accordingly, the internal processor in the target voltage circuit 48 uses the target voltage LUT to generate the single voltage target V_{TGT} for the voltage modulation intervals S_{X-1} and S_{X+1}. Further, the internal processor in the target voltage circuit 48 generates the target voltage indications V_{TGT}(i) (i = X-1, X, X+1) and provides the target voltage indications V_{TGT}(i) to the PMIC 18 via the inter-chip interface 26. In an embodiment, the target voltage LUT may store the various levels of voltage targets in digital formats. In this regard, the target voltage circuit 48 may also include an internal DAC (not shown) to convert the voltage targets V_{TGT-1}-V_{TGT-N} or the single voltage target V_{TGT} into respective analog formats in the target voltage indications V_{TGT}(i).

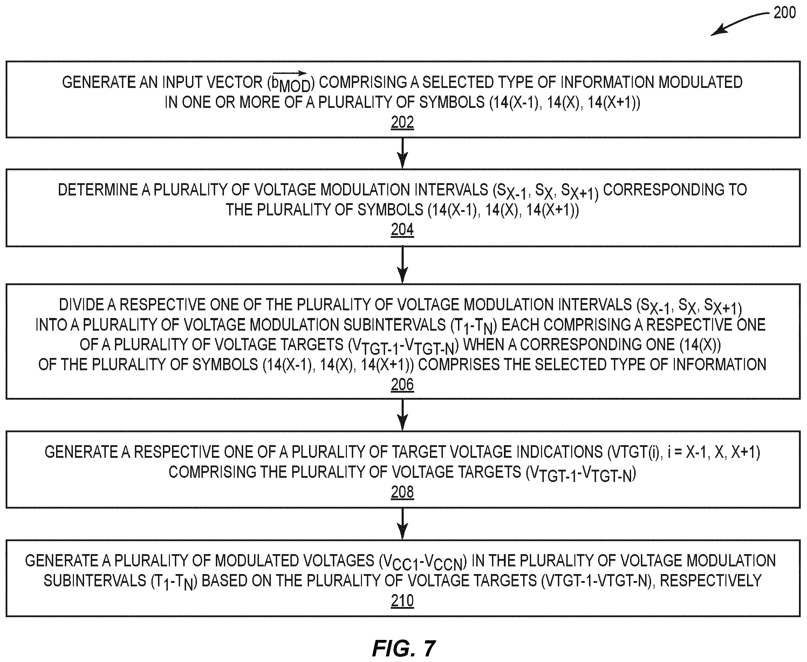

The transmission circuit 16 of Figure 2 can be configured to enable inter-symbol and intra-symbol voltage modulation based on a process. In this regard, Figure 7 is a flowchart of an example process 200 for enabling inter-symbol and intra-symbol voltage modulation according to embodiments of the present disclosure.

Herein, the digital baseband circuit 44 is configured to generate an input vector b̅_̅{̅M̅O̅D̅}̅ modulated to include the selected type of information in one or more (e.g., symbol 14(X)) of the symbols 14(X-1), 14(X), 14(X+1) (step 202). The target voltage circuit 48 is configured to determine the voltage modulation intervals S_{X-1}, S_{X}, S_{X+1} corresponding to the symbols 14(X-1), 14(X), 14(X+1) (step 204). The target voltage circuit 48 then divides a respective one (e.g., voltage modulation interval S_{X}) of the voltage modulation intervals S_{X-1}, S_{X}, S_{X+1} into the voltage modulation subintervals T₁-T_{N}, each of the voltage modulation subintervals includes a respective one of the voltage targets V_{TGT-1}-V_{TGT-N} when the target voltage circuit 48 determines that a corresponding one (e.g., symbol 14(X)) of the symbols 14(X-1), 14(X), 14(X+1) includes the selected type of information (step 206). The target voltage circuit 48 then generates a respective one of the target voltage indications V_{TGT}(i) (i = X-1, X, X+1) that includes the voltage targets V_{TGT-1}-V_{TGT-N} (step 208). The voltage generation circuit 30 will then generate the modulated voltages V_{CC1}-V_{CCN} in the voltage modulation subintervals T₁-T_{N} based on the voltage targets V_{TGT-1}-V_{TGT-N}, respectively (step 210).

Therefore, from one perspective, there have been described a circuit and method for inter-symbol and intra-symbol voltage method. A transceiver circuit is configured to determine a voltage target(s) for generating a modulated voltage(s) to amplify a radio frequency (RF) signal modulated in multiple symbols. Specifically, the transceiver circuit will generate multiple voltage targets for any of the symbols to thereby enable intra-symbol voltage modulation when the respective symbol is modulated to carry a selected type of information or generate a single voltage target for any of the symbols to thereby enable inter-symbol voltage modulation when the respective symbol lacks the selected type of information. By dynamically performing inter-symbol and intra-symbol voltage modulation based on the type of information carried in a symbol(s), the modulated voltage can be timely adapted to closely track a time-variant power envelope of the RF signal to thereby avoid potential distortion and protect critical information in the RF signal.

Those skilled in the art will recognize improvements and modifications to the preferred embodiments of the present disclosure. All such improvements and modifications are considered within the scope of the concepts disclosed herein and the claims that follow.

## Claims

1. A transceiver circuit (20) comprising:
a digital baseband circuit (44) configured to generate an input vector (bMOD) comprising a selected type of information modulated in one or more of a plurality of symbols; and
a target voltage circuit (48) configured to:
determine a plurality of voltage modulation intervals (S_{X-1}, S_{X}, S_{X+1}) corresponding to the plurality of symbols, respectively;
divide a respective one of the plurality of voltage modulation intervals into a plurality of voltage modulation subintervals (T₁-T_{N})
each comprising a respective one of a plurality of voltage targets (V_{TGT-1}..V_{TGT-N}) when a corresponding one of the plurality of symbols comprises the selected type of information; and
generate a respective one of a plurality of target voltage indications (VTGT(i), i=X-1, X,X+1) comprising the plurality of voltage targets.

2. The transceiver circuit of claim 1, wherein the selected type of information comprises one or more of: physical downlink control channel**,** PDCCH, information, physical uplink control channel**,** PUCCH, information, physical downlink shared channel**,** PDSCH, information, and physical uplink shared channel**,** PUSCH, information.

3. The transceiver circuit of claim 1 or 2, wherein each of the plurality of symbols is an orthogonal frequency division multiplexing**,** OFDM, symbol.

4. The transceiver circuit of claim 1, 2 or 3, wherein the target voltage circuit is further configured to perform one selected from the group comprising: equally divide the respective one of the plurality of voltage modulation intervals into the plurality of voltage modulation subintervals.; and unequally divide the respective one of the plurality of voltage modulation intervals into the plurality of voltage modulation subintervals.

5. The transceiver circuit of any preceding claim, wherein the target voltage circuit is further configured to generate the respective one of the plurality of target voltage indications comprising a single voltage target when the corresponding one of the plurality of symbols does not contain the selected type of information.

6. The transceiver circuit of any preceding claim, further comprising a signal processing circuit configured to generate a radio frequency (RF) signal from the input vector.

7. A transmission circuit comprising:
the transceiver circuit of any preceding claim; and
a power management integrated circuit**,** PMIC, comprising a voltage generation circuit configured to:
receive the plurality of target voltage indications from the transceiver circuit; and
generate a plurality of modulated voltages in the plurality of voltage modulation subintervals based on the plurality of voltage targets, respectively.

8. The transmission circuit of claim 7, wherein the PMIC further comprises:
an inter-chip interface coupled to the transceiver circuit to receive the plurality of target voltage indications; and
a memory circuit configured to store the plurality of received target voltage indications.

9. The transmission circuit of claim 7 or 8, wherein the PMIC is further configured to receive the respective one of the plurality of target voltage indications corresponding to the respective one of the plurality of voltage modulation intervals during an immediately preceding one of the plurality of voltage modulation intervals.

10. The transmission circuit of claim 7, 8 or 9, wherein the voltage generation circuit is further configured to generate each of the plurality of modulated voltages based on the respective one of the plurality of voltage targets no later than a respective start of the respective one of the plurality of voltage modulation subintervals, for example wherein the voltage generation circuit is further configured to:
generate a respective one of the plurality of modulated voltages prior to the respective start of the respective one of the plurality of voltage modulation subintervals in response to the respective one of the plurality of voltage targets indicating that the respective one of the plurality of modulated voltages will increase during the respective one of the plurality of voltage modulation subintervals; and
generate the respective one of the plurality of modulated voltages at the respective start of the respective one of the plurality of voltage modulation subintervals in response to the respective one of the plurality of voltage targets indicating that the respective one of the plurality of modulated voltages will decrease during the respective one of the plurality of voltage modulation subintervals.

11. The transmission circuit of any of claims 7 to 10, wherein the target voltage circuit is further configured to generate a single voltage target for the respective one of the plurality of voltage modulation intervals when the respective one of the plurality of symbols does not contain the selected type of information, for example wherein the voltage generation circuit is further configured to generate a single modulated voltage during the respective one of the plurality of voltage modulation intervals based on the single voltage target.

12. A method for enabling inter-symbol and intra-symbol voltage modulation comprising:
generating (202) an input vector comprising a selected type of information modulated in one or more of a plurality of symbols;
determining (204) a plurality of voltage modulation intervals corresponding to the plurality of symbols, respectively;
dividing (206) a respective one of the plurality of voltage modulation intervals into a plurality of voltage modulation subintervals each comprising a respective one of a plurality of voltage targets when a corresponding one of the plurality of symbols comprises the selected type of information;
generating (208) a respective one of a plurality of target voltage indications comprising the plurality of voltage targets; and
generating (210) a plurality of modulated voltages in the plurality of voltage modulation subintervals based on the plurality of voltage targets, respectively.

13. The method of claim 12, further comprising receiving the respective one of the plurality of target voltage indications corresponding to the respective one of the plurality of voltage modulation intervals during an immediately preceding one of the plurality of voltage modulation intervals.

14. The method of claim 12 or 13, further comprising generating each of the plurality of modulated voltages based on the respective one of the plurality of voltage targets no later than a respective start of the respective one of the plurality of voltage modulation subintervals, for example further comprising:
generating a respective one of the plurality of modulated voltages prior to the respective start of the respective one of the plurality of voltage modulation subintervals in response to the respective one of the plurality of voltage targets indicating that the respective one of the plurality of modulated voltages will increase during the respective one of the plurality of voltage modulation subintervals; and
generating the respective one of the plurality of modulated voltages at the respective start of the respective one of the plurality of voltage modulation subintervals in response to the respective one of the plurality of voltage targets indicating that the respective one of the plurality of modulated voltages will decrease during the respective one of the plurality of voltage modulation subintervals.

15. The method of claim 12, 13 or 14, further comprising generating a single voltage target for the respective one of the plurality of voltage modulation intervals when the respective one of the plurality of symbols does not contain the selected type of information, for example further comprising generating a single modulated voltage during the respective one of the plurality of voltage modulation intervals based on the single voltage target.

## Patentansprüche

1. Sendeempfängerschaltung (20), umfassend:
eine digitale Basisbandschaltung (44), die dazu ausgelegt ist, einen Eingangsvektor (bMOD) zu erzeugen, der einen ausgewählten Typ von Informationen umfasst, die in einem oder mehreren einer Vielzahl von Symbolen moduliert sind; und
eine Zielspannungsschaltung (48), die ausgelegt ist zum:
Bestimmen einer Vielzahl von Spannungsmodulationsintervalle (S_{X-1}, S_{X}, S_{X+1}), die jeweils der Vielzahl von Symbolen entsprechen;
Teilen eines jeweiligen der Vielzahl von Spannungsmodulationsintervallen in eine Vielzahl von Spannungsmodulationsteilintervallen (T₁-T_{N}), die jeweils ein jeweiliges einer Vielzahl von Spannungszielen (V_{TGT-1}..V_{TGT-N}) umfassen, wenn ein entsprechendes der Vielzahl von Symbolen den ausgewählten Typ von Informationen umfasst; und
Erzeugen einer jeweiligen einer Vielzahl von Zielspannungsangaben (VTGT(i), i=X-1, X,X+1), die die Vielzahl von Spannungszielen umfassen.

2. Sendeempfängerschaltung nach Anspruch 1, wobei der ausgewählte Typ von Informationen eines oder mehrere von Folgendem umfasst: Informationen eines physischen Downlink-Steuerkanals, PDCCH, Informationen eines physischen Uplink-Steuerkanals, PUCCH, Informationen eines physischen gemeinsam genutzten Downlink-Kanals, PDSCH, und Informationen eines physischen gemeinsam genutzten Uplink-Kanals, PUSCH.

3. Sendeempfängerschaltung nach Anspruch 1 oder 2, wobei jedes der Vielzahl von Symbolen ein Orthogonal-Frequenzmultiplexing- bzw. OFDM-Symbol ist.

4. Sendeempfängerschaltung nach Anspruch 1, 2 oder 3, wobei die Zielspannungsschaltung ferner dazu ausgelegt ist, eines durchzuführen, das aus der Gruppe ausgewählt ist, die Folgendes umfasst: gleichmäßiges Teilen des jeweiligen einen der Vielzahl von Spannungsmodulationsintervallen in die Vielzahl von Spannungsmodulationsteilintervallen; und ungleichmäßiges Teilen des jeweiligen einen der Vielzahl von Spannungsmodulationsintervallen in die Vielzahl von Spannungsmodulationsteilintervallen.

5. Sendeempfängerschaltung nach einem der vorhergehenden Ansprüche, wobei die Zielspannungsschaltung ferner dazu ausgelegt ist, die jeweilige der Vielzahl von Zielspannungsangaben zu erzeugen, die ein einzelnes Spannungsziel umfassen, wenn das entsprechende eine der Vielzahl von Symbolen den ausgewählten Typ von Informationen nicht enthält.

6. Sendeempfängerschaltung nach einem der vorhergehenden Ansprüche, ferner umfassend eine Signalverarbeitungsschaltung, die dazu ausgelegt ist, ein Funkfrequenz(RF)-Signal aus dem Eingangsvektor zu erzeugen.

7. Übertragungsschaltung, umfassend:
die Sendeempfängerschaltung nach einem der vorhergehenden Ansprüche; und
eine integrierte Leistungsmanagementschaltung, PMIC, die eine Spannungserzeugungsschaltung umfasst, die ausgelegt ist zum:
Empfangen der Vielzahl von Zielspannungsangaben von der Sendeempfängerschaltung; und
Erzeugen einer Vielzahl von modulierten Spannungen in der Vielzahl von Spannungsmodulationsteilintervallen jeweils basierend auf der Vielzahl von Spannungszielen.

8. Übertragungsschaltung nach Anspruch 7, wobei die PMIC ferner umfasst:
eine Inter-Chip-Schnittstelle, die mit der Sendeempfängerschaltung gekoppelt ist, um die Vielzahl von Zielspannungsangaben zu empfangen; und
eine Speicherschaltung, die dazu ausgelegt ist, die Vielzahl von empfangenen Zielspannungsangaben zu speichern.

9. Übertragungsschaltung nach Anspruch 7 oder 8, wobei die PMIC ferner dazu ausgelegt ist, die jeweilige eine der Vielzahl von Zielspannungsangaben, die dem jeweiligen einen der Vielzahl von Spannungsmodulationsintervallen entsprechen, während eines unmittelbar vorhergehenden der Vielzahl von Spannungsmodulationsintervallen zu empfangen.

10. Übertragungsschaltung nach Anspruch 7, 8 oder 9, wobei die Spannungserzeugungsschaltung ferner dazu ausgelegt ist, jede der Vielzahl von modulierten Spannungen basierend auf dem jeweiligen einen der Vielzahl von Spannungszielen spätestens zu einem jeweiligen Start des jeweiligen einen der Vielzahl von Spannungsmodulationsteilintervallen zu erzeugen, wobei zum Beispiel die Spannungserzeugungsschaltung ferner ausgelegt ist zum:
Erzeugen einer jeweiligen einen der Vielzahl von modulierten Spannungen vor dem jeweiligen Start des jeweiligen einen der Vielzahl von Spannungsmodulationsteilintervallen als Reaktion darauf,
dass das jeweilige eine der Vielzahl von Spannungszielen angibt, dass die jeweilige eine der Vielzahl von modulierten Spannungen während des jeweiligen einen der Vielzahl von Spannungsmodulationsteilintervallen ansteigen wird; und
Erzeugen der jeweiligen einen der Vielzahl von modulierten Spannungen am jeweiligen Start des jeweiligen einen der Vielzahl von Spannungsmodulationsteilintervallen als Reaktion darauf,
dass das jeweilige eine der Vielzahl von Spannungszielen angibt, dass die jeweilige eine der Vielzahl von modulierten Spannungen während des jeweiligen einen der Vielzahl von Spannungsmodulationsteilintervallen abnehmen wird.

11. Übertragungsschaltung nach einem der Ansprüche 7 bis 10, wobei die Zielspannungsschaltung ferner dazu ausgelegt ist, ein einzelnes Spannungsziel für das jeweilige eine der Vielzahl von Spannungsmodulationsintervallen zu erzeugen, wenn das jeweilige eine der Vielzahl von Symbolen den ausgewählten Typ von Informationen nicht enthält, wobei zum Beispiel die Spannungserzeugungsschaltung ferner dazu ausgelegt ist, eine einzelne modulierte Spannung während des jeweiligen einen der Vielzahl von Spannungsmodulationsintervallen basierend auf dem einzelnen Spannungsziel zu erzeugen.

12. Verfahren zum Ermöglichen einer Inter-Symbol- und Intra-Symbol-Spannungsmodulation, umfassend:
Erzeugen (202) eines Eingangsvektors, der einen ausgewählten Typ von Informationen umfasst, die in einem oder mehreren einer Vielzahl von Symbolen moduliert sind;
Bestimmen (204) einer Vielzahl von Spannungsmodulationsintervallen, die jeweils der Vielzahl von Symbolen entsprechen;
Teilen (206) eines jeweiligen der Vielzahl von Spannungsmodulationsintervallen in eine Vielzahl von Spannungsmodulationsteilintervallen, die jeweils ein jeweiliges einer Vielzahl von Spannungszielen umfassen,
wenn ein entsprechendes der Vielzahl von Symbolen den ausgewählten Typ von Informationen umfasst;
Erzeugen (208) einer jeweiligen einen einer Vielzahl von Zielspannungsangaben, die die Vielzahl von Spannungszielen umfassen; und
Erzeugen (210) einer Vielzahl von modulierten Spannungen in der Vielzahl von Spannungsmodulationsteilintervallen jeweils basierend auf der Vielzahl von Spannungszielen.

13. Verfahren nach Anspruch 12, ferner umfassend Empfangen der jeweiligen einen der Vielzahl von Zielspannungsangaben, die dem jeweiligen einen der Vielzahl von Spannungsmodulationsintervallen entsprechen, während eines unmittelbar vorhergehenden der Vielzahl von Spannungsmodulationsintervallen.

14. Verfahren nach Anspruch 12 oder 13, ferner umfassend Erzeugen von jeder der Vielzahl von modulierten Spannungen basierend auf dem jeweiligen einen der Vielzahl von Spannungszielen spätestens zu einem jeweiligen Start des jeweiligen einen der Vielzahl von Spannungsmodulationsteilintervallen, zum Beispiel ferner umfassend:
Erzeugen einer jeweiligen einen der Vielzahl von modulierten Spannungen vor dem jeweiligen Start des jeweiligen einen der Vielzahl von Spannungsmodulationsteilintervallen als Reaktion darauf, dass das jeweilige eine der Vielzahl von Spannungszielen angibt, dass die jeweilige eine der Vielzahl von modulierten Spannungen während des jeweiligen einen der Vielzahl von Spannungsmodulationsteilintervallen ansteigen wird; und
Erzeugen der jeweiligen einen der Vielzahl von modulierten Spannungen am jeweiligen Start des jeweiligen einen der Vielzahl von Spannungsmodulationsteilintervallen als Reaktion darauf, dass das jeweilige eine der Vielzahl von Spannungszielen angibt, dass die jeweilige eine der Vielzahl von modulierten Spannungen während des jeweiligen einen der Vielzahl von Spannungsmodulationsteilintervallen abnehmen wird.

15. Verfahren nach Anspruch 12, 13 oder 14, ferner umfassend Erzeugen eines einzelnen Spannungsziels für das jeweilige eine der Vielzahl von Spannungsmodulationsintervallen, wenn das jeweilige eine der Vielzahl von Symbolen den ausgewählten Typ von Informationen nicht enthält, zum Beispiel ferner umfassend Erzeugen einer einzelnen modulierten Spannung während des jeweiligen einen der Vielzahl von Spannungsmodulationsintervallen basierend auf dem einzelnen Spannungsziel.

## Revendications

1. Circuit émetteur-récepteur (20) comprenant :
un circuit de bande de base numérique (44) configuré pour générer un vecteur d'entrée (bMOD) comprenant un type sélectionné d'informations modulées dans un ou plusieurs symboles d'une pluralité de symboles ; et
un circuit de tension cible (48) configuré pour :
déterminer une pluralité d'intervalles de modulation de tension (S_{X-1}, S_{X}, S_{X+1}) correspondant respectivement à la pluralité de symboles ;
diviser un intervalle respectif de la pluralité d'intervalles de modulation de tension en une pluralité de sous-intervalles de modulation de tension (T₁-T_{N}) comprenant chacun une cible respective d'une pluralité de cibles de tension (V_{TGT-1}..V_{TGT-N}) lorsqu'un symbole correspondant de la pluralité de symboles comprend le type d'information sélectionné ; et
générer une indication respective parmi une pluralité d'indications de tension cible (VTGT(i), i=X-1, X, X+1) comprenant la pluralité de cibles de tension.

2. Circuit émetteur-récepteur selon la revendication 1, dans lequel le type d'information sélectionné comprend une ou plusieurs des types suivants : informations de canal de commande de liaison descendante physique, PDCCH, informations de canal de commande de liaison montante physique, PUCCH, informations de canal partagé de liaison descendante physique, PDSCH, et informations de canal partagé de liaison montante physique, PUSCH.

3. Circuit émetteur-récepteur selon la revendication 1 ou 2, dans lequel chacun symbole de la pluralité de symboles est un symbole de multiplexage par répartition orthogonale de la fréquence (OFDM).

4. Circuit émetteur-récepteur selon la revendication 1, 2 ou 3, dans lequel le circuit de tension cible est en outre configuré pour exécuter une opération sélectionnée dans le groupe comprenant : la division en portions égales de l'intervalle respectif de la pluralité d'intervalles de modulation de tension en la pluralité de sous-intervalles de modulation de tension ; et la division en portions inégales de l'intervalle respectif de la pluralité d'intervalles de modulation de tension en la pluralité de sous-intervalles de modulation de tension.

5. Circuit émetteur-récepteur selon l'une quelconque des revendications précédentes, dans lequel le circuit de tension cible est en outre configuré pour générer l'indication respective parmi la pluralité d'indications de tension cible comprenant une cible de tension unique lorsque le symbole correspondant de la pluralité de symboles ne contient pas le type d'information sélectionné.

6. Circuit émetteur-récepteur selon l'une quelconque des revendications précédentes, comprenant en outre un circuit de traitement de signal configuré pour générer un signal radiofréquence (RF) à partir du vecteur d'entrée.

7. Circuit de transmission comprenant :
le circuit émetteur-récepteur selon l'une quelconque des revendications précédentes ; et
un circuit intégré de gestion d'alimentation, PMIC, comprenant un circuit de génération de tension configuré pour :
recevoir la pluralité d'indications de tension cible en provenance du circuit émetteur-récepteur ; et
générer une pluralité de tensions modulées dans la pluralité de sous-intervalles de modulation de tension sur la base de la pluralité de cibles de tension, respectivement.

8. Circuit de transmission selon la revendication 7, dans lequel le PMIC comprend en outre :
une interface inter-puce couplée au circuit émetteur-récepteur pour recevoir la pluralité d'indications de tension cible ; et
un circuit de mémoire configuré pour stocker la pluralité d'indications de tension cible reçues.

9. Circuit de transmission selon la revendication 7 ou 8, dans lequel le PMIC est en outre configuré pour recevoir l'indication respective de la pluralité d'indications de tension cible correspondant à l'intervalle respectif parmi la pluralité d'intervalles de modulation de tension pendant un intervalle immédiatement précédent de la pluralité d'intervalles de modulation de tension.

10. Circuit de transmission selon la revendication 7, 8 ou 9, dans lequel le circuit de génération de tension est en outre configuré pour générer chaque tension de la pluralité de tensions modulées sur la base de la cible respective parmi la pluralité de cibles de tension au plus tard lors d'un début respectif du sous-intervalle respectif de la pluralité de sous-intervalles de modulation de tension, le circuit de génération de tension étant en outre configuré, par exemple, pour :
générer une tension respective de la pluralité de tensions modulées avant le début respectif du sous-intervalle respectif de la pluralité de sous-intervalles de modulation de tension en réponse au fait que la cible respective de la pluralité de cibles de tension indique que la tension respective de la pluralité de tensions modulées augmentera pendant le sous-intervalle respectif de la pluralité de sous-intervalles de modulation de tension ; et
générer une tension respective de la pluralité de tensions modulées au début respectif du sous-intervalle respectif de la pluralité de sous-intervalles de modulation de tension en réponse au fait que la cible respective de la pluralité de cibles de tension indique que la tension respective de la pluralité de tensions modulées diminuera pendant le sous-intervalle respectif de la pluralité de sous-intervalles de modulation de tension.

11. Circuit de transmission selon l'une quelconque des revendications 7 à 10, dans lequel le circuit de tension cible est en outre configuré pour générer une cible de tension unique pour l'intervalle respectif de la pluralité d'intervalles de modulation de tension lorsque le symbole respectif de la pluralité de symboles ne contient pas le type d'information sélectionné, le circuit de génération de tension étant en outre configuré, par exemple, pour générer une tension modulée unique pendant l'intervalle respectif de la pluralité d'intervalles de modulation de tension sur la base de la cible de tension unique.

12. Procédé pour permettre une modulation de tension inter-symbole et intra-symbole, comprenant :
la génération (202) d'un vecteur d'entrée comprenant un type sélectionné d'information modulé dans un ou plusieurs symboles parmi une pluralité de symboles ;
la détermination (204) dune pluralité d'intervalles de modulation de tension correspondant respectivement à la pluralité de symboles ;
la division (206) d'un intervalle respectif parmi la pluralité d'intervalles de modulation de tension en une pluralité de sous-intervalles de modulation de tension comprenant chacun une cible respective parmi une pluralité de cibles de tension lorsqu'un symbole correspondant parmi la pluralité de symboles comprend le type d'information sélectionné ;
la génération (208) d'une indication respective parmi une pluralité d'indications de tension cible comprenant la pluralité de cibles de tension ; et
la génération (210) d'une pluralité de tensions modulées dans la pluralité de sous-intervalles de modulation de tension sur la base, respectivement, de la pluralité de cibles de tension.

13. Procédé selon la revendication 12, comprenant en outre la réception de l'indication respective de la pluralité d'indications de tension cible correspondant à l'intervalle respectif parmi la pluralité d'intervalles de modulation de tension pendant un intervalle immédiatement précédent de la pluralité d'intervalles de modulation de tension.

14. Procédé selon la revendication 12 ou 13, comprenant en outre la génération de chaque tension de la pluralité de tensions modulées sur la base de la cible respective de la pluralité de cibles de tension au plus tard lors d'un début respectif du sous-intervalle respectif de la pluralité de sous-intervalles de modulation de tension, comprenant par exemple en outre :
la génération d'une tension respective de la pluralité de tensions modulées avant le début respectif du sous-intervalle respectif de la pluralité de sous-intervalles de modulation de tension en réponse au fait que la cible respective de la pluralité de cibles de tension indique que la tension respective de la pluralité de tensions modulées augmentera pendant le sous-intervalle respectif de la pluralité de sous-intervalles de modulation de tension ; et
la génération de la tension respective de la pluralité de tensions modulées au début respectif du sous-intervalle respectif de la pluralité de sous-intervalles de modulation de tension en réponse au fait que la cible respective de la pluralité de cibles de tension indique que la tension respective de la pluralité de tensions modulées diminuera pendant le sous-intervalle respectif de la pluralité de sous-intervalles de modulation de tension.

15. Procédé selon la revendication 12, 13 ou 14, comprenant en outre la génération d'une cible de tension unique pour l'intervalle respectif de la pluralité d'intervalles de modulation de tension lorsque le symbole respectif de la pluralité de symboles ne contient pas le type d'information sélectionné, comprenant en outre, par exemple, la génération d'une tension modulée unique pendant l'intervalle respectif de la pluralité d'intervalles de modulation de tension sur la base de la cible de tension unique.
